Europäisches Patentamt

European Patent Office

Office européen des brevets

(11) Numéro de publication: **0 181 806**
**A1**

(12) **DEMANDE DE BREVET EUROPEEN**

(21) Numéro de dépôt: **85402072.4**

(22) Date de dépôt: **25.10.85**

(51) Int. Cl.⁴: **G 01 R 1/073**

(30) Priorité: **30.10.84 FR 8416596**

(43) Date de publication de la demande:
**21.05.86 Bulletin 86/21**

(84) Etats contractants désignés:
**DE GB IT**

(71) Demandeur: **SOCAPEX**
**10 bis, quai Léon Blum**
**F-92153 Suresnes(FR)**

(72) Inventeur: **Bricaud, Hervé**
**THOMSON-CSF SCPI-173, bld Hausmann**
**F-75379 Paris Cedex 08(FR)**

(72) Inventeur: **Tossuto, Jean-François**
**THOMSON-CSF SCPI-173, bld Hausmann**
**F-75379 Paris Cedex 08(FR)**

(74) Mandataire: **Ruellan-Lemonnier, Brigitte et al,**
**THOMSON-CSF SCPI 19, avenue de Messine**
**F-75008 Paris(FR)**

(54) **Pince-test de circuit intégré.**

(57) Cette invention concerne un système de connexion entre un circuit intégré, encapsulé dans un "micro-boîtier à connexions périmétriques" ou "MICOP" céramique, et les dispositifs de test dynamique (par exemple entre un microprocesseur et un analyseur logique). Ce système de connexion est une pince-test (10) qui se compose d'un corps isolant (11) comportant à sa périphérie un nombre de contacts-test (20) égal au nombre d'entrées-sorties du "MICOP" (5) installé ou non dans son connecteur (2). Des leviers d'accrochage (40) articulés sur le corps (11) permettent de verrouiller la pince-test (10). Enfin, un circuit imprimé (29) fixé sur le corps isolant (11) permet le câblage du câble de liaison sur la pince-test (10).

FIG_3

EP 0 181 806 A1

# PINCE TEST DE CIRCUIT INTEGRE

L'invention a pour objet une pince test de circuit intégré.

Elle concerne un système de connexion entre un circuit intégré, encapsulé dans un micro-boîtier à connexions périmétriques (plus connu sous l'appellation anglo-saxonne "Chip-carrier") ou "MICOP" céramique, monté ou non dans un connecteur support de "MICOP", et les dispositifs de test dynamique (par exemple entre un microprocesseur et un analyseur logique).

Ce système est indispensable pour les tests de prototypes et en production de matériels équipés des nouvelles générations de composants que sont les "MICOP", et il simplifie le service Après-Vente et le contrôle qualité.

L'art antérieur est constitué par l'ensemble des pinces test développées pour les boîtiers "DIL" (Dual-in-line package). Ces pinces se connectent directement sur la zone protubérante des broches de sortie du boîtier "DIL" située au-dessus :

- du circuit imprimé lorsque le boîtier "DIL" est brasé sur la carte,

- du connecteur-support lorsque le boîtier "DIL" est monté dans un tel connecteur.

La conception de ces types de pince-test les rend inaptes au test des boîtiers "MICOP" placés ou non dans leur connecteur-support; en effet, leur principe repose sur celui de la "pince à linge" dont chacune des deux machoires est équipée d'une rangée de contacts venant en appui sur les broches du boîtier "DIL" sous l'action du serrage exercé par le ressort de la pince. Cette structure est difficilement applicable à un boîtier à connexions périmétriques "MICOP" placé ou non dans un connecteur support muni également de broches de connexions sur ses quatre côtés; et de toute façon, elle imposerait l'accessibilité des broches du connecteur de "MICOP" par les côtés latéraux, ce qui n'est pas toujours le cas.

Ces deux dernières remarques justifient le choix pour l'accessibilité du corps de chacun des contacts du connecteur de "MICOP" par le haut afin de permettre le test dynamique de "MICOP" dans ce connecteur à l'aide d'un nouveau type de pince-test dont l'originalité et la facilité d'emploi fait l'objet de cette invention. Cette accessibilité est citée dans les demandes françaises de brevet :

- N° 83 03 131 déposée le 25 février 1983 et intitulée "CONNECTEUR COMPRENANT AU MOINS UN CONTACT PRESENTANT UN BRAS ELASTIQUEMENT DEFORMABLE" pour ce qui concerne l'embase;

- N° 83 17 912 déposée le 10 novembre 1983 et intitulée "CONNECTEUR A FORCE D'INSERTION NULLE POUR SUPPORT RECTANGULAIRE DE CIRCUIT ET PINCE DE FERMETURE POUR UN TEL CONNECTEUR" pour ce qui concerne le ressort de verrouillage.

L'invention a pour objet une pince-test de circuit intégré, caractérisée en ce qu'elle comprend un corps isolant qui comporte un certain nombre de contacts destinés à venir en liaison avec les entrées-sorties du circuit intégré, deux leviers reliés entre eux par au moins une entretoise, chaque levier ayant sa partie inférieure qui se termine par au moins un crochet, chaque levier comportant une articulation de manière à permettre une rotation par rapport à un axe parallèle à ces entretoises, ces leviers étant articulés sur ce corps, un circuit imprimé fixé sur ce corps isolant, et un câble de liaison qui est connecté à ce circuit imprimé.

L'invention sera mieux comprise à l'aide des exemples de réalisation suivants, donnés à titre non limitatif, conjointement avec les figures qui représentent :

- les figures 1 et 2, deux vues d'un micro-boîtier à connexions périmétriques dans son connecteur;

- les figures 3 et 4, deux vues de la pince-test selon l'invention;

- les figures 5, 6 et 7, trois vues d'une partie de la pince-test selon l'invention;

3

- la figure 8, une vue d'une partie de la pince-test selon l'invention, une fois connectée avec un câble de liaison;

- la figure 9, une vue de dessus du dessin d'implantation sur la carte-support d'un "MICOP" ou d'un connecteur de "MICOP";

- la figure 10, un plot de brasure de la carte-support lorsqu'un "MICOP" est brasé directement sur celle-ci;

- les figures 11 à 17, des vues de différentes parties de la pince-test selon l'invention, celle-ci utilisant des contact-tests glissants;

- la figure 18, une variante de la pince-test selon l'invention;

- les figures 19 et 20, deux vues illustrant l'utilisation de la pince-test selon l'invention avec un "MICOP" brasé directement sur une carte-support;

- les figures 21 à 26, des vues illustrant l'utilisation d'une pince-test et d'un "MICOP" à double rangée de plots d'entrée-sortie.

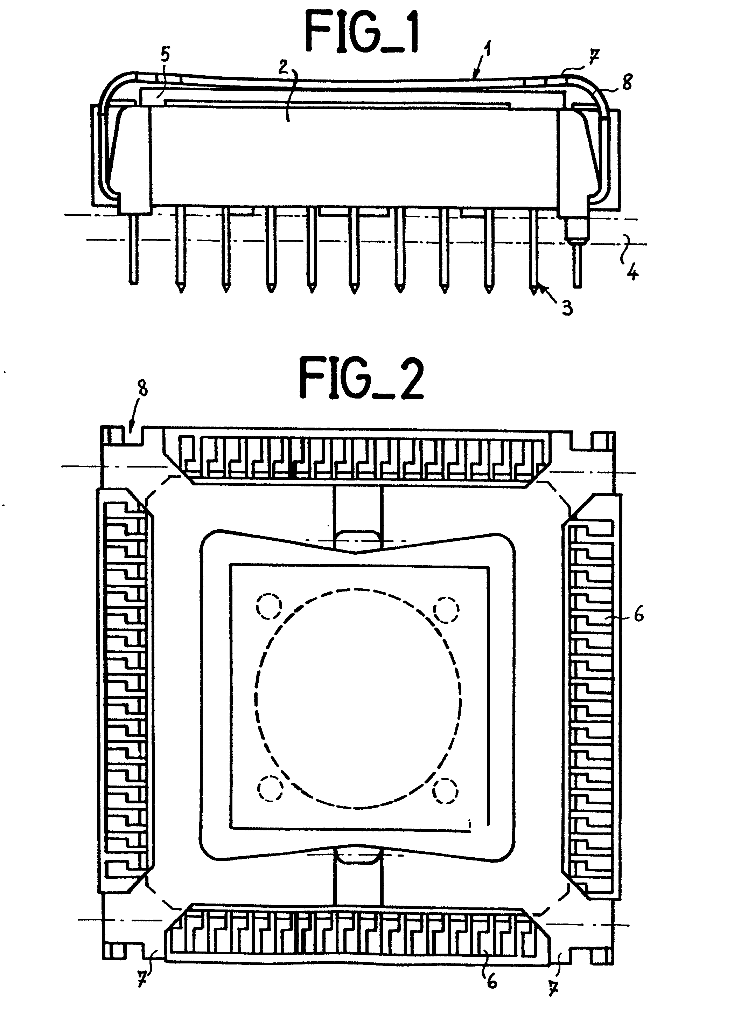

Les figures 1 et 2 montrent respectivement une vue de côté et une vue de dessus d'un connecteur 2 fermé sur un "chip-carrier" 5. Celui-ci est positionné, sans effort d'insertion, en appui sur la rangée de contacts périmétriques 3 dans l'embase 2 du connecteur. Le corps, moulé en matière plastique, de l'embase 2 présente une cavité dont le contour interne est à l'image du contour externe du chip-carrier 5. Lors du positionnement du chip-carrier 5 dans l'embase 2, il faut donc mettre en concordance les coins de détrompage respectifs. (La plate-forme d'appui inférieure de la cavité de l'embase n'est pas représentée sur la figure). Le connecteur est ensuite fermé en verrouillant la pince 1 sur l'embase 2. Ce verrouillage est réalisé en exerçant une pression au niveau des quatre angles de la pince de verrouillage 1. Sous cette pression, les becquets des crochets de la pince glissent sur les pentes de guidage de l'embase jusqu'à l'encliquetage des becquets dans les logements plans correspondants de l'embase 2. Au cours de l'opération de verrouillage, les bras d'appui de la pince se déforment de façon élastique en exerçant une force d'appui sur le chip-carrier; sous l'action de cette force d'appui, le chip-carrier s'enfonce dans la

4

cavité interne de l'embase en déformant de façon élastique les contacts 3 de l'embase jusqu'à ce que le chip-carrier bute contre la plate-forme d'appui inférieure de la cavité.

La forme et la structure de la pince de verrouillage 1 ont été déterminées de façon à ce qu'après encliquetage, la force d'appui exercée par la pince sur le chip-carrier soit égale ou supérieure à la somme des forces d'appui de l'ensemble des contacts 3 sur les plots du chip-carrier.

Par ailleurs, la pince permet, après verrouillage, l'accès à l'arrière des contacts pour un éventuel test électrique en fonctionnement. Enfin, elle présente une ouverture centrale suffisamment large pour laisser le passage à un éventuel radiateur de refroidissement fixé directement sur le chip-carrier et schématisé par le contour.

Sur la figure 2, le connecteur 2 comporte des accès 6 au corps des contacts 3 pour les tests en fonctionnement. La pince de verrouillage 1 comprend des tétons d'appui 7 qui permettent l'effet de bras de levier de l'outil de déverrouillage du contact.

Dans la suite de la description illustrée par les figures, la pince-test selon l'invention sera indistinctement utilisée avec un circuit intégré monté dans son connecteur, ou avec un circuit intégré directement brasé sur sa carte support.

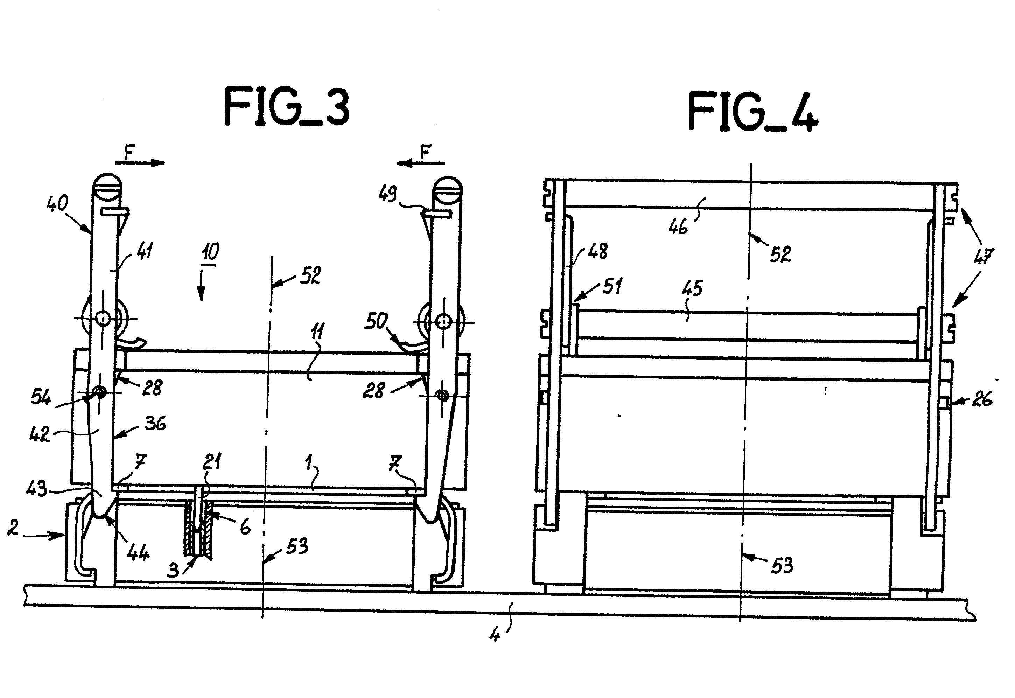

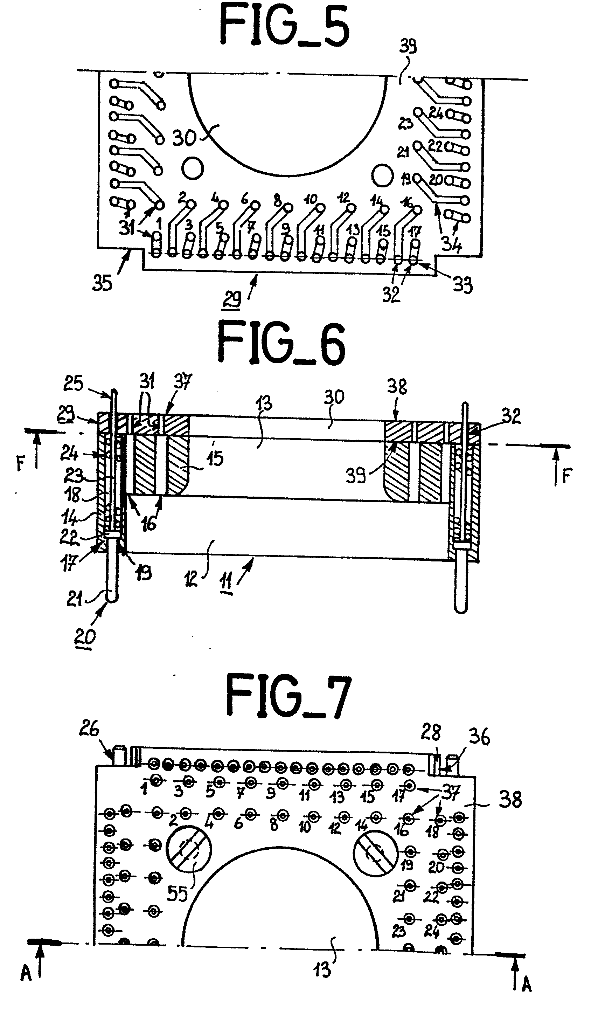

La pince-test 10 telle que représentée aux figures 3 à 7 se compose d'un corps isolant 11 comportant à sa périphérie un nombre de contacts-test 20 égal au nombre d'entrées-sorties du "MICOP" 5 installé dans son connecteur 2. Des leviers d'accrochage 40 articulés sur le corps 11 permettent de verrouiller la pince-test 10 sur le connecteur de "MICOP". Enfin, un circuit imprimé 29 fixé sur le corps isolant 11 permet le câblage du câble de liaison sur la pince-test 10.

La pince-test 10 est positionnée sur l'ensemble formé par le boîtier "MICOP" 5 tel que représenté aux figures 1 et 2 installé dans son connecteur. Les contacts-test 20 viennent en appui sur la zone accessible des contacts 3 correspondants du connecteur de "MICOP".

5

Les pentes d'accrochage 44 des bras inférieurs 42 coopèrent avec les tétons d'appui 7 de la pince de verrouillage 1 du connecteur pour faire pivoter légèrement les leviers 40 de la pince-test 10 qui se verrouillent automatiquement par encliquetage sur les tétons 7 de la pince 1 lorsque la position relative acquise par la pince-test 10 sur le connecteur est celle requise pour garantir un bon contact électrique des contacts-test 20 avec les contacts 3 du connecteur de "MICOP".

Le centrage de la pince-test 10 sur le connecteur, dans le plan formé par les entretoises 45 et 46, est assuré par les parois internes 8 des dégagements des coins de la pince-test 1 qui guident dans ce plan les leviers 40 de la pince-test 10.

Les actions combinées des pentes 44 des quatre crochets 43 sur les tétons 7 s'équilibrent pour assurer l'autocentrage de la pince-test 10 sur le connecteur de "MICOP" dans le plan perpendiculaire aux axes des entretoises 45 et 46. Le centrage final dans ce plan est obtenu après encliquetage par l'appui des bras inférieurs 42 contre les faces d'arrêt 36 du corps 11 de la pince-test 10.

Ainsi, après encliquetage, les axes 52 et 53 de la pince-test 10 et du connecteur de "MICOP" sont confondus.

Le maintien de la position verrouillée de la pince-test 10 sur le connecteur de "MICOP" est garanti par l'action des ressorts 51 (axés sur les entretoises 45 des leviers 40) qui, sous l'effet de leur bras de pression 50 sur le sommet de la pince-test 10, transmettent par leur bras de levier 48, un couple de rotation aux leviers 40 autour de leur articulation 26, interdisant ainsi tout désencliquetage intempestif de la pince-test et permettant à l'opérateur de relâcher cette dernière et réaliser tous les tests désirés en toute sécurité de fonctionnement.

La surface projetée sur la carte-support 4 de la pince-test 10 sera de préférence égale ou légèrement inférieure, à celle du connecteur de "MICOP" pour permettre le test simultané, à l'aide de plusieurs pinces-test, de plusieurs "MICOP" installés dans des connecteurs montés au contact l'un de l'autre sur tous les côtés.

Pour déverrouiller la pince-test 10 du connecteur de "MICOP", il suffit de presser avec deux doigts de la main sur les deux entretoises 46 dans le sens des flèches F indiquées figure 3. La rotation des leviers 40 ainsi provoquée permet le désencliquetage des crochets 43 qui se dégagent des tétons 7. Sous l'action des contacts test "à pompe" 20 qui se détendent en exerçant un effort vertical vers le haut, la pince-test 10 est alors soulevée et peut être aisément retirée du connecteur de "MICOP". Les pentes 28 du corps isolant 11 permettent, grâce aux dégagements correspondants, la rotation des bras de levier 40 et limitent cette rotation pour éviter que les bras inférieurs 42 ne sortent du volume formé par les plans des parois latérales externes de l'embase 2 de connecteur de "MICOP", et ne viennent percuter les pinces-test ou les connecteurs de "MICOP" éventuellement montés au contact du premier. De préférence, le bord externe du bras inférieur 42 présente une pente de valeur sensiblement égale à celle de la pente 28 pour éviter que l'extrémité du bras 42 sorte du volume précisé ci-dessus. Ceci est particulièrement intéressant lorsque le bras 42 est prolongé pour permettre d'autres utilisations de la pince-test 10.

Sur la figure 3, les leviers 40 sont positionnés, dans des logements du corps 11, légèrement en retrait du contour extérieur de la pince-test 10.

Pour différentes tailles de circuits intégrés, la pince-test de l'invention conserve la même forme, seuls le corps 11 et le circuit intégré ont leurs tailles adaptées à celles du "MICOP" ainsi que les entretoises utilisées dans les différents cas qui ont des longueurs différentes; en effet, les hauteurs des connecteurs sont constantes.

Le contact-test "à pompe" 20 illustré à la figure 6, réalisé en matériau conducteur électrique comprend :

- un doigt de contact 21 qui coopère avec le contact 3 correspondant du connecteur de "MICOP" à tester;

- une tige tutrice 23 de diamètre inférieur à celui du doigt 21;

- une collerette 22 de diamètre supérieur à celui du doigt 21 et située entre ce dernier et la tige tutrice 23;

- un ressort de pression à boudin 24, enfilé sur la tige tutrice 23, qui assure la force d'appui du contact-test 20 sur le contact 3 du connecteur de "MICOP", nécessaire pour garantir un contact électrique stable entre ces deux éléments.

L'alvéole de chaque contact-test 20 est formée par :

- un trou de guidage 19, de la paroi latérale 14 du corps isolant 11, dans lequel coulisse le doigt de contact 21;

- un logement 18, de section supérieure à celle du trou 19, qui contient le ressort de pression 24 et la tige tutrice 23;

- une face de retenue 17, formée par le changement de section entre le trou 19 et le logement 18, sur laquelle vient s'appuyer la collerette 22 du contact-test 20 en position repos.

L'alvéole est fermée à sa partie supérieure par le circuit imprimé 29 dont le trou métallisé 32 correspondant, de diamètre inférieur à celui du ressort de pression 24, assure le passage et le guidage de l'extrémité supérieure de la tige tutrice 23 lorsque le contact-test 20 coulisse dans son alvéole. L'extrémité supérieure du ressort de compression 24 vient en appui sur la pastille 33 du trou métallisé de guidage 32. Les hauteurs du logement 18 et du ressort 24 à l'état libre, sont déterminées de façon à produire la force d'appui voulue lorsque la pince-test 10 est verrouillée sur le connecteur de "MICOP"; à titre d'exemple, nous avons choisi dans notre application les hauteurs suivantes : 7 mm pour le logement 18, et 9 mm pour le ressort à l'état libre.

La liaison électrique entre le doigt de contact 21 et le trou métallisé correspondant est assurée par :

- le ressort de pression conducteur électrique 24 dont :

. l'extrémité inférieure est en appui sur la collerette 22 et les spires en contact de la tige tutrice 23 sur toute la longueur de celle-ci,

. l'extrémité supérieure est en appui sur la pastille 33 du trou métallisé 32 du circuit imprimé 29,

- la piste conductrice 34 servant de liaison entre la pastille 33 du trou métallisé 32 et le trou métallisé 31 servant à la brasure du fil correspondant du câble de liaison extérieur.

Il existe également une liaison électrique directe entre le contact-test 20 et le trou métallisé 32 par l'intermédiaire de l'extrémité 25 de la tige tutrice 23 qui frotte sur la paroi interne du trou métallisé 32 en passant à travers celui-ci. Mais la qualité de ce contact électrique, qui se superpose à celui décrit ci-dessus, n'est pas garantie car aucune force d'appui contrôlée n'est exercée entre l'extrémité de la tige tutrice et le trou métallisé 32, comme dans le cas précédent, grâce au ressort 24.

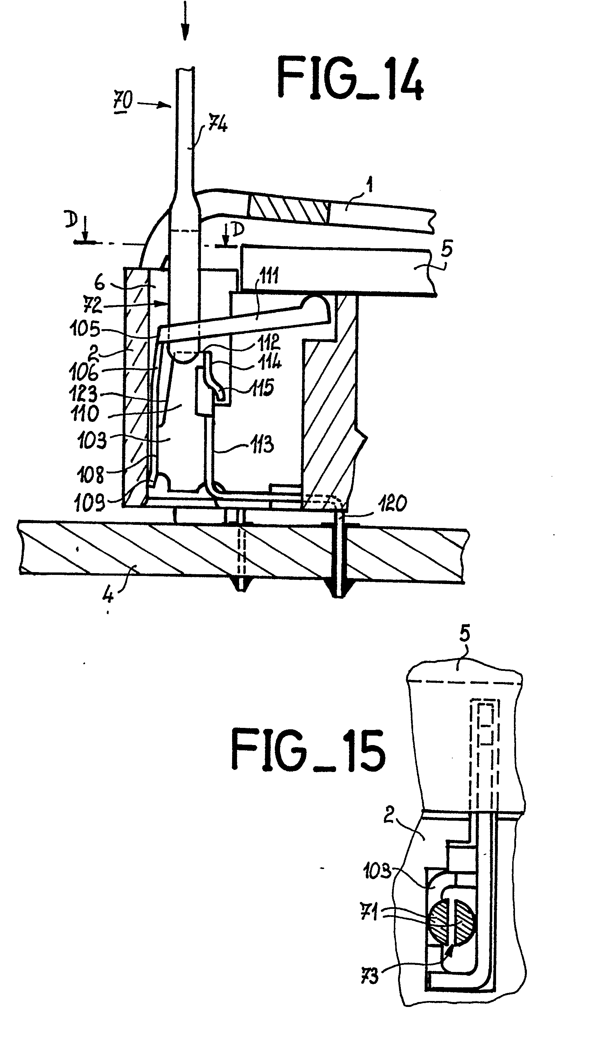

Lors du positionnement de la pince-test 10 sur le connecteur de "MICOP", le doigt 21 du contact-test 20 pénètre dans un premier temps dans la partie supérieure 6 de l'alvéole du connecteur de "MICOP", assurant de cette façon un préguidage du doigt de contact vers la partie arrière du contact 3, c'est-à-dire la partie supérieure du corps en U de ce dernier décrit dans la demande de brevet N° 83 03 131 qui sera considéré ultérieurement à la figure 14.

Lorsque la pince-test 10 est verrouillée sur le connecteur de "MICOP" comme représenté à la figure 3, chaque contact-test "à pompe" 20 est en appui sur le contact 3 correspondant établissant ainsi une liaison électrique, par l'intermédiaire de ce dernier, entre le plot d'entrée-sortie du "MICOP" (qui peut être en fonctionnement) et le fil correspondant du câble de liaison branché sur le dispositif de test dynamique.

Les ressorts de pression 24 absorbent les légères différences de hauteur des contacts 3 du connecteur dues aux tolérances de fabrication. Les caractéristiques de ces ressorts sont telles que les faibles différences de hauteur des contacts 3 provoquent des variations de force d'appui négligeables entre chacun d'entre eux et sans effet sur la valeurs de résistances de contact électrique. D'autre part, la force d'appui du contact-test 20 s'exerce sur la partie supérieure du corps en U du contact 3, c'est-à-dire sur une partie rigide de celui-ci : il n'y a donc pas de risque de perturbation du contact électrique entre le contact 3 du connecteur et le plot correspondant du "MICOP", comme cela aurait été le cas si le contact-test 20 avait pris son appui sur la partie élastique du contact 3.

9

Les parois isolantes de l'alvéole 6 évitent tout risque de court-circuit entre deux contacts 3 adjacents par le contact-test 20 lors d'un mauvais positionnement de la pince-test 10, ou d'une approche malencontreuse de cette dernière, ou encore avec une pince-test présentant un contact-test 20 déformé.

On notera que la pince de verrouillage 1, ayant fait l'objet de la demande de brevet N° 83 17 912, a été conçue de façon à ce que son contour extérieur dégage complètement la totalité des entrées 6 des alvéoles permettant ainsi l'accès direct (par le haut) des contacts 3 du connecteur par les contacts-test 20 de la pince-test 10.

Le circuit imprimé 29 est fixé sur la base 15 du corps isolant 11 de la pince-test, à l'aide des vis 55 dans notre exemple : ainsi il maintient les contacts-test 20 et leurs ressorts 24 prisonniers dans leurs alvéoles. La pince-test 10 peut être livrée sous cette forme à l'utilisateur, qui optera, en fonction de ses besoins, pour le mode de raccordement de son choix avec le câble de liaison du dispositif de test.

Plusieurs possibilités peuvent être envisagées pour le raccordement de la pince-test 10 avec le câble de liaison 57, par exemple :

- contacts insérés à force dans le circuit 29 pour constituer une fiche déconnectable;

- fourches auto-dénudantes insérées à force dans le circuit 29 pour raccorder un câble en nappe;

- fourches "relais" insérées dans le circuit pour braser les fils du câble 57;

- brasure directe des fils du câble de liaison sur le circuit 29.

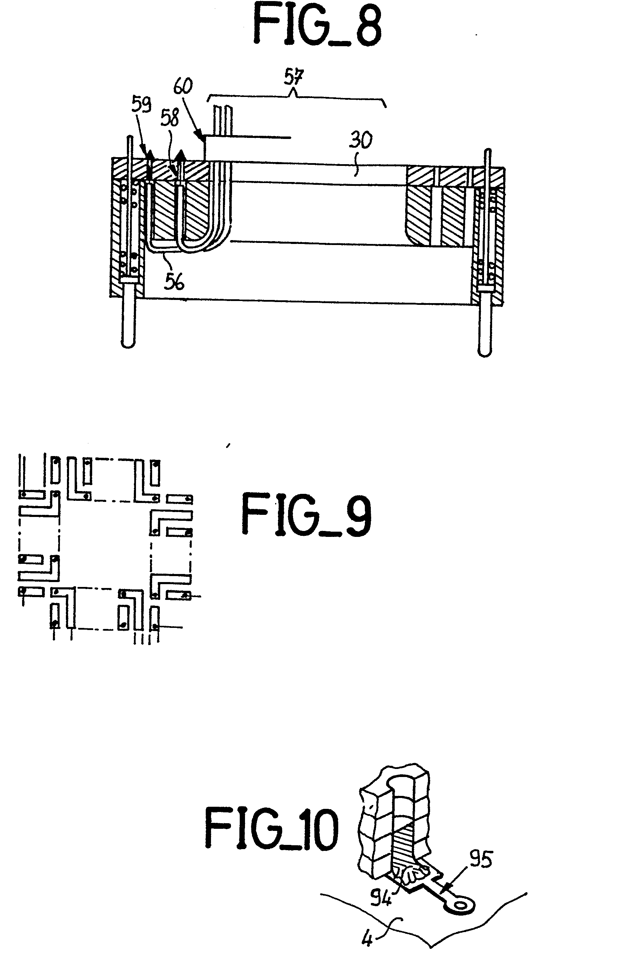

C'est cette dernière solution qui est présentée à titre d'exemple de l'invention sur la figure 8.

Le toron du câble de liaison 57 est introduit dans la pince-test par l'ouverture 30 du circuit 29 prolongée par le trou de passage 13 du corps isolant 11. L'extrémité du toron de fil est alors épanouie à l'intérieur du logement interne 12 pour diriger chaque fil 56 vers le trou guide-fil 16 qui lui correspond. Le repérage de ceux-ci est facilité par exemple par le fait que leur implantation est identique à celle des bornes de sortie des contacts 3 du connecteur de "MICOP" sur la carte-support 4 représentés à la figure 9 : il est donc très aisé de faire une corrélation entre le trou guide-fil 16 et le numéro du plot de sortie du "MICOP" auquel le fil 56 est affecté. Le guide-fil 16 facilite l'insertion de l'extrémité dénudée 58 du fil 56 dans le trou métallisé 31. Le fil 56 est poussé dans le guide-fil jusqu'à ce que la gaine vienne en butée contre la face intérieure 39 du circuit 29. L'extrémité dénudée 58 qui traverse alors le circuit 29 est brasée dans le trou métallisé 31 sur la pastille 37 de la face extérieure 38 du circuit 29.

Lorsque l'ensemble des fils 36 est brasé sur le circuit 29, le toron est tendu vers l'extérieur de la pince-test et bloqué dans cette position à l'aide du serre-câble 60 par exemple. Ce dernier maintient les fils 56 dans le logement 12 du corps isolant 11. Le raccordement ainsi obtenu est clair et très propre.

Les picots 25 des contacts-test 20 qui dépassent du circuit 29 peuvent être éventuellement utilisés pour une prise de test individuelle à l'aide d'un "grippe-fil" par exemple. Cette prise de test individuelle peut être opérée parallèlement au test global effectué par le dispositif de test dynamique via le câble de liaison.

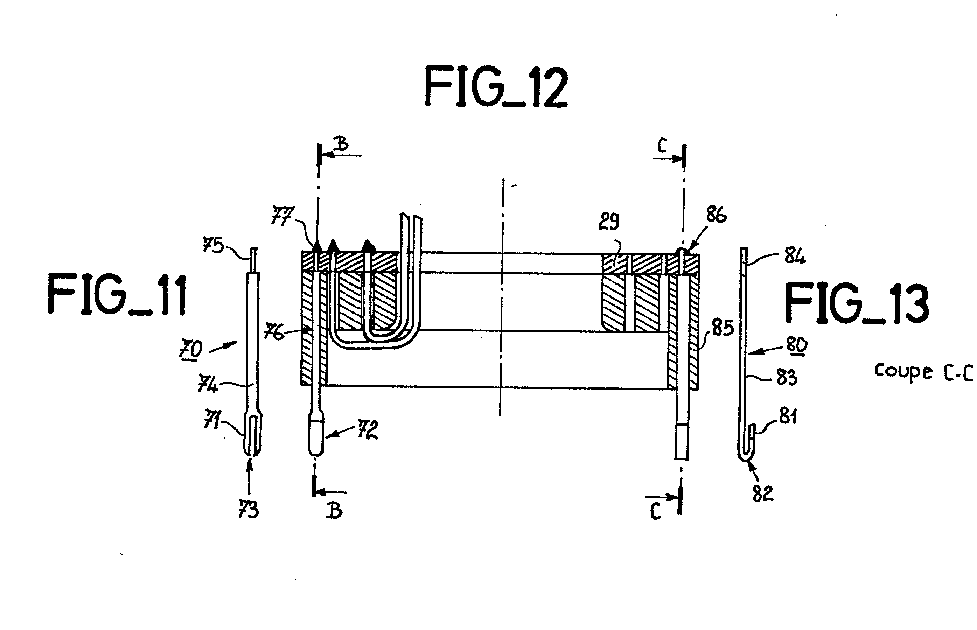

Une solution technique différente du système "à pompe" peut être choisie pour le contact de la pince-test 10 : il s'agit du contact glissant dont 2 versions sont présentées à titre d'exemple aux figures 11 à 17.

Contrairement au contact-test "à pompe" 20 qui est du type à force d'insertion nulle (Z.E.I.F.), le contact-test glissant doit être enfiché dans l'alvéole 6 du contact 3 du connecteur de "MICOP" et assurer le contact électrique avec celui-ci grâce à une pression latérale exercée sur une partie de ce contact 3 par serrage de la tête élastiquement déformable du contact-test.

Cette solution technique est particulièrement bien adaptée au "connecteur de "MICOP" comprenant des contacts présentant un bras élastiquement déformable" ayant fait l'objet de la demande de brevet N° 83 03 131. En effet, l'entrée de l'alvéole 6 contenant le contact 3 qui a un corps en forme de U et un bras élastique constitue le réceptacle de la tête du contact-test glissant de la pince-test 10. Dans cette demande de brevet N° 83 03 131, le contact électrique, comme représenté à la figure 14, comporte un corps 103 en forme de U, dont l'axe longitudinal est représenté par convention vertical, et présentant un fond 110 et deux ailes, la première référencée 108 étant d'un seul tenant, et la seconde comprenant une partie inférieure 113 et une partie supérieure 114 situées dans le même plan et séparées par une languette élastique de rétention 115. La deuxième aile présente à l'extrémité de sa partie inférieure 113 une borne de sortie 120.

La partie supérieure 114 de la deuxième aile se raccorde à la partie supérieure du fond 110 par une zone de pliage. La partie supérieure 114 se prolonge vers le bas par la languette élastique 115. La languette élastique 115 présente une région élastique formant ressort constituant le prolongement inférieur de la partie supérieure 114 de la deuxième aile, un bras incliné formant un dièdre d'environ 150° avec la région élastique et un pied dirigé approximativement dans la direction verticale et qui assure le verrouillage proprement dit de la languette. Entre la languette 115 et le fond 110 subsiste une fente.

L'aile 108 se prolonge à sa partie supérieure par un bras ressort vertical 106. A sa partie inférieure, elle est reliée à une languette de pression 109 par une zone de pliage de telle sorte que la languette 109 s'étende vers l'extérieur de l'aile 108.

Le rebord latéral du bras ressort 106 situé à l'opposé du fond du U 110 présente à son extrémité supérieure une zone de pliage 105 autour de laquelle est replié un levier 111 dont l'axe est incliné par rapport à l'horizontale (par exemple de l'ordre de 18°) de telle sorte que son extrémité formant une crosse soit située au-dessus de la partie supérieure 112 du corps 110 du contact. Le bras ressort 106 est séparé du corps 110 par une fente bordée d'un côté par un bord du bras ressort 106 et d'autre part, par le bord 123 du corps du

12

contact 110. Le levier 111 reçoit l'effort vertical d'application du substrat lors de l'insertion de celui-ci mais reste relativement rigide étant donné que cet effort est dirigé suivant la face latérale supérieure du levier 111. D'autre part, étant donné que l'effort est d'axe vertical, c'est-à-dire selon l'axe du bras ressort 106, celui-ci ne subit pas d'effort tranchant, mais seulement un moment fléchissant, autrement dit le bras ressort 106 fonctionne pratiquement en flexage pur, les efforts de compression longitudinale pouvant être négligés. Dans ce cas, la forme idéale est un bras d'égale largeur et d'égale épaisseur ce qui permet de réaliser un bras ressort 106 de forme optimale par simple découpe dans l'aile 108 du U.

L'une des deux branches (ou lame) de la tête déformable par pincement du contact-test vient en appui contre la paroi de l'alvéole 6, et la deuxième branche (ou lame) vient, sous déformation élastique, en appui latéral sur le bras du contact 3, établissant le contact électrique avec ce dernier, comme illustré à la figure 15. La force d'appui étant exercée latéralement sur le bras du contact 3, il n'y a donc pas de risque de perturbation du contact électrique entre le contact 3 du connecteur et le plot correspondant du "MICOP".

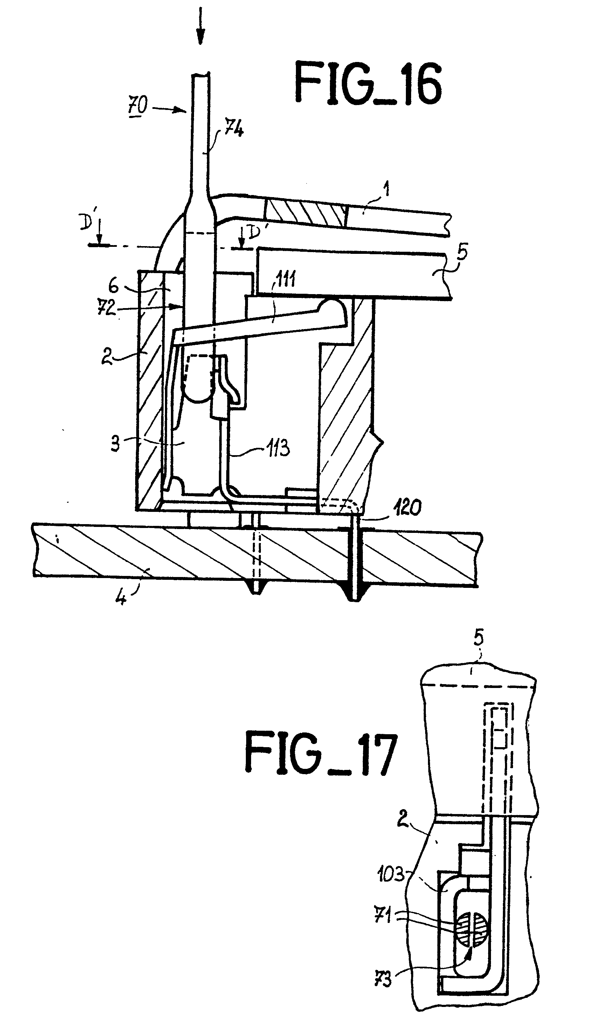

Les figures 16 et 17 présentent une variante de la solution technique présentée au paragraphe précédant : la tête déformable du contact glissant est plus fine de façon à pénétrer à l'intérieur de la cage formée par le corps en U et le bras déformable du contact 3. L'avantage de cette variante est d'établir deux points de contact électrique : l'un sur le corps en U, l'autre sur le bras du contact 3.

Le contact-test 70 de la figure 11 qui est considéré à titre d'exemple aux figures 14, 15, 16 et 17, est composé d'une tête fendue 72 dont les deux branches souples 71 séparées par la fente 73 forment une lyre et peuvent se déformer élastiquement par pincement lors de son insertion dans l'alvéole 6 du contact 3 du connecteur de "MICOP".

La tête fendue 72 est solidaire d'une tige 74 logée dans l'alvéole 76 du corps isolant 11 de la pince-test 10. La tige 74 est prolongée à son extrémité supérieure d'un picot 75 dont l'insertion et la brasure 77 dans le trou métallisé 32 du circuit imprimé 29 assurent à la fois la fixation mécanique du contact-test 70 dans la pince-test 10 et l'interconnexion électrique vers le câble de liaison 57 via les pistes 34.

Le contact-test 80 de la figure 13 est composé d'une lame 83 dont l'extrémité inférieure se termine par une branche recourbée 81 et forme la tête "Cantilever" 82 du contact-test 80. La branche 81 peut se déformer élastiquement par pincement lors de son insertion dans l'alvéole 6 du contact 3 du connecteur de "MICOP". La lame 83, logée dans son alvéole 85 du corps isolant 11, est prolongée à son extrémité supérieure d'un picot 84 assurant la fixation mécanique 86 et l'interconnexion électrique du contact-test 80 sur la pince-test 10.

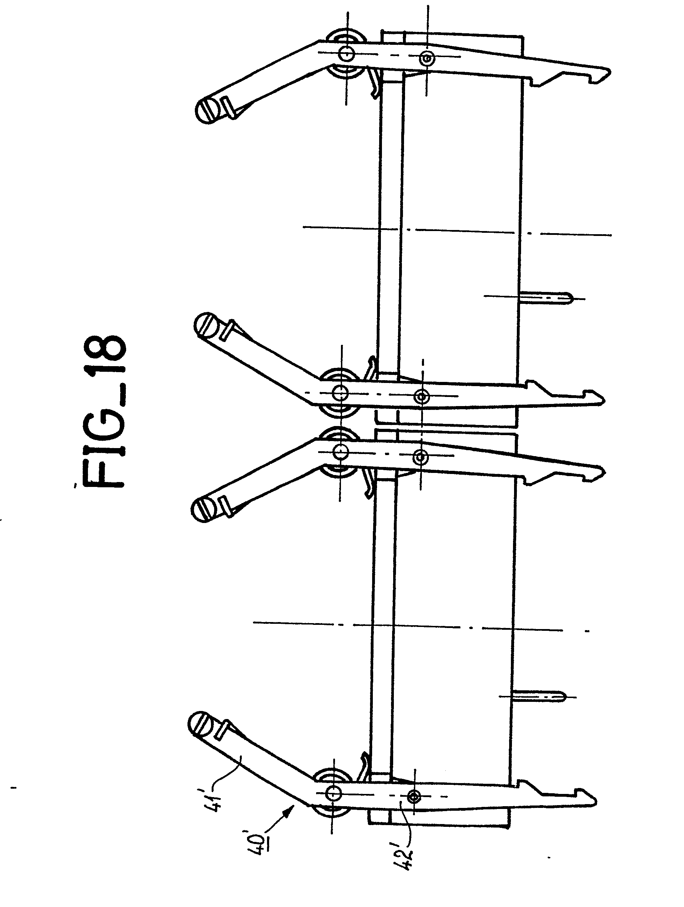

Dans une variante de l'invention représentée à la figure 18, le bras supérieur 41' du levier d'accrochage 40' forme un angle d'environ 150° avec le bras inférieur 42'. Cette forme permet d'augmenter la distance séparant les entretoises 46 de deux pinces-test employées simultanément sur deux connecteurs de "MICOP" montés au contact l'un de l'autre. Cela facilite les manipulations de verrouillage et de déverrouillage d'une pince-test en présence d'une autre voisine.

La pince-test 10, dans sa version à contacts-test "à pompe" peut également être utilisée pour le test dynamique d'un "MICOP" directement reporté sur la carte-support.

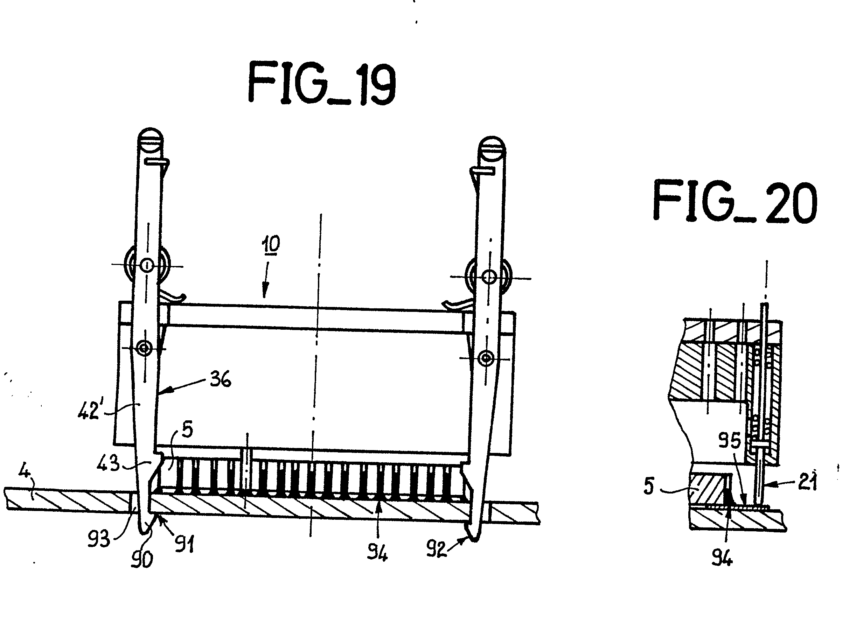

En effet, les plots de report 95 de la carte-support 4 (voir figures 19 et 20) dépassent le contour du "MICOP" sur une longueur d'environ 1 à 2 mm. Ce plot de report permet la formation du congé de brasure 94 sur le bord du "MICOP", la partie restante du plot 95 est généralement utilisée pour les contrôles, les réparations ou les modifications de la carte.

Comme ce plot 95 est dans l'axe de l'alvéole 6 du contact 3 du connecteur (lorsque ce dernier est placé entre le "MICOP" et la carte-support) il est donc possible d'utiliser la même pince-test 10 dans les deux configurations envisagées :

14

- "MICOP" monté dans son connecteur (configuration décrite précédemment);

- "MICOP" brasé directement sur la carte-support.

Dans ce deuxième cas, les contacts-test 10 "à pompe" viennent en appui sur le plot de report 95 (voir figure 10) de la carte-support 4. Le maintien de la pince-test 10 sur cette dernière pendant toute la durée du test dynamique peut être assuré, par exemple, par des petits crochets 90 qui s'encliquent dans quatre trous 93 percés dans la carte-support 4 au quatre coins du "MICOP".

Les crochets 90 sont situés à l'extrémité des bras inférieurs 42' des leviers d'accrochage qui ont donc été modifiés pour cette utilisation. Cette modification consiste à prolonger les bras inférieurs 42, précédemment décrits, pour leur adjoindre de petits crochets supplémentaires 90. Le bras 42' conserve le crochet 43, bien qu'inutile lorsque la pince-test est utilisée avec un "MICOP" reporté directement sur la carte-support, car ainsi celle-ci est utilisable indifféremment avec ou sans connecteur de "MICOP" pour le test dynamique du "MICOP".

Les crochets 90 sont munis d'une pente d'encliquetage 92 pour faciliter leur insertion dans les trous 93 de la carte-support 4.

On notera que le bord 91 du petit crochet 90 est, de préférence, dans le prolongement du bord du bras inférieur 42' venant en appui sur la face d'arrêt 36 du corps isolant 11. De cette manière, le crochet 90 n'a pas d'action sur les tétons 7 de la pince 1 lors du verrouillage de la pince-test 10 sur un connecteur de "MICOP". Après verrouillage, les crochets 90 se trouvent dans le vide à l'intérieur des dégagements de l'embase 2.

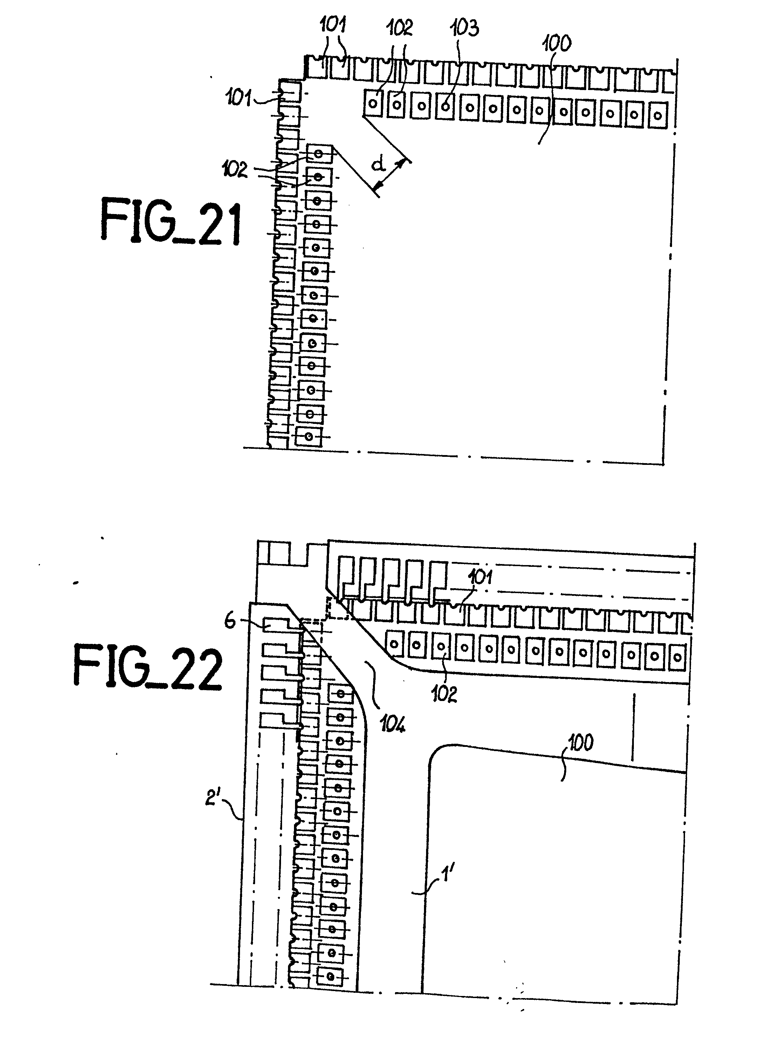

Une nouvelle génération de micro-boîtier se développe pour réduire l'encombrement lorsque le nombre de plots d'entrée-sortie devient trop élevé : supérieur à 100 par exemple (voir figure 21).

Ces micro-boîtiers 100 se distinguent des "chip-carriers" classiques par le fait qu'ils présentent deux rangées de plots alternées sur les quatre côtés et sur les deux faces. La rangée externe des plots 101 est similaire à celle des "chip-carriers" classiques.

Chaque plot 102 de la rangée interne présente un trou métallisé 103 qui assure la liaison électrique avec le plot correspondant de l'autre face et permet la remontée et le contrôle de la brasure du plot inférieur lorsque le micro-boîtier est brasé directement sur la carte-support. De cette caractéristique, provient l'appellation anglo-saxonne généralement attribuée à ces micro-boîtiers : "Open-Via-Chip-Carrier" ou "O.V.C.C.".

Il est à noter que dans chaque coin de l'"O.V.C.C." les plots extrêmes de deux rangées internes 102 adjacentes présentent entre eux un espace libre de distance "d", largement plus importante que celle existant au niveau des plots extrêmes des rangées internes 101. Cela s'explique pour des raisons de passage des intraconnexions des plots vers la cavité centrale des micro-boîtiers recevant la pastille semi-conductrice.

De ce fait, en examinant la figure 22, on s'aperçoit que lorsque l'"O.V.C.C." est monté dans l'embase 2' de son connecteur, l'attache 104 des fixations de la pince de verrouillage 1' de ce dernier découvre la totalité des plots 102 des rangées internes. Ce qui n'est évidemment pas le cas des plots d'extrémité des rangées externes 101 puisque deux plots 101 au moins sont recouverts en chaque coin du micro-boîtier par la pince 1'.

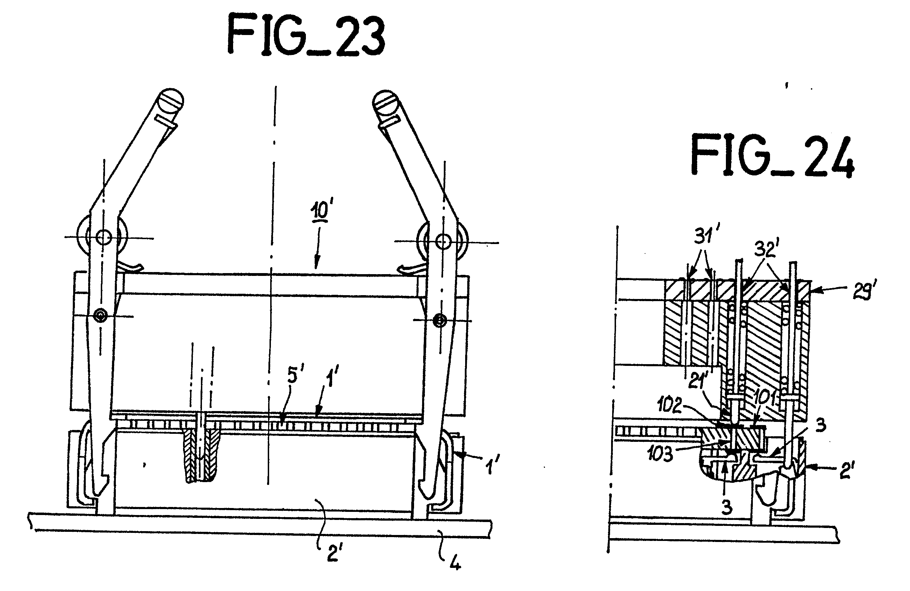

En combinant les caractéristiques de l'invention présentées précédemment (pour le test dynamique d'un "chip-carrier" classique monté dans son connecteur ou brasé directement sur la carte-support), il est donc possible de réaliser une pince-test 10' équipée à sa périphérie de contacts-test "à pompe" sur deux rangées alternées (voir figures 23 et 24) :

- les contacts-test externes correspondant aux plots de la rangée externe de l'"O.V.C.C." travaillent dans les alvéoles externes 6 de l'embase du connecteur (ces contacts-test sont identiques à ceux décrits précédemment);

- les contacts-test internes correspondant aux plots de la rangée interne de l'"O.V.C.C." prennent leur appui directement sur les plots 102 des rangées internes de la face supérieure de l'"O.V.C.C." puisque ceux-ci sont tous accessibles (ce qui n'est pas le cas, d'ailleurs, des contacts 3 et des alvéoles associées du connecteur correspondant aux plots 102 de l'"O.V.C.C."). Pour compenser la différence de niveau des points d'appui de ces contacts-test par rapport à ceux de la rangée externe, le doigt de contact 21' des contacts-test de la rangée interne sont raccourcis.

Le système de positionnement de la pince-test 10' sur le connecteur de l'"O.V.C.C." est identique à celui décrit précédemment.

Le câblage du câble de liaison sur la pince-test 10' suit le même procédé que celui décrit précédemment mais les trous métalliques 31' pour la brasure des fils du câble de liaison sur le circuit imprimé 29' sont dans ce cas par exemple disposés sur deux rangées alternées de même "pas" que les trous métallisés 32' de guidage des contacts-test "à pompe" ou sur quatre rangées alternées au "pas" double de ces dernières.

Des liaisons électriques assurent l'interconnexion entre les trous métallisés de guidage 32' avec ceux de la rangée correspondante des trous métallisés de brasure 31'.

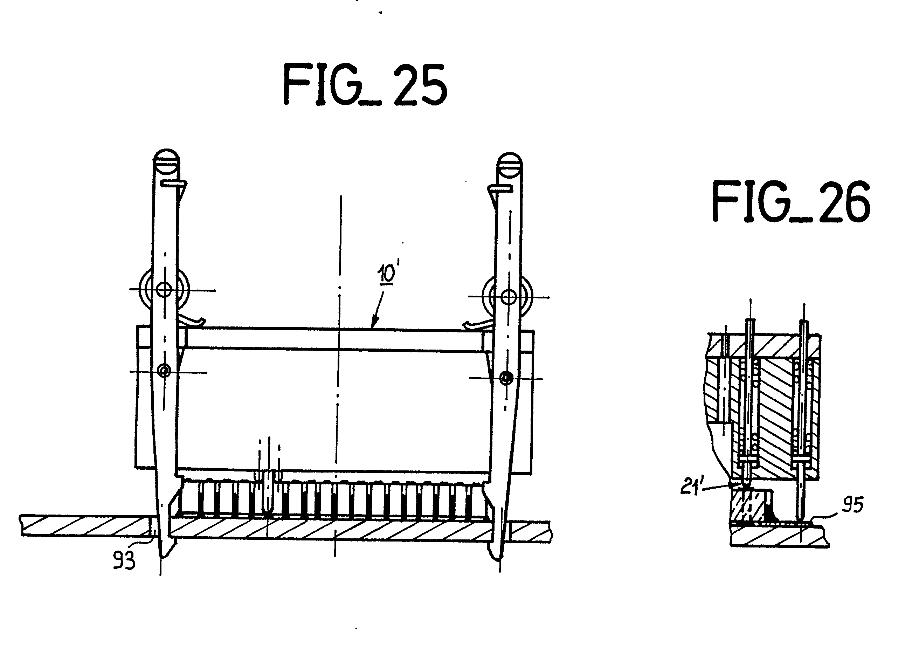

Les figures 25 et 26 présentent la pince-test 10' utilisée pour le test dynamique d'un "O.V.C.C." directement brasé sur la carte-support. Dans ce cas, les bras inférieurs 42' des leviers d'accrochage doivent être nécessairement munis des petits crochets 90 permettant leur encliquetage dans les trous 93 de la carte-support. La pince-test 10' est alors indifféremment utilisable pour le test dynamique d'"O.V.C.C." avec ou sans connecteur intermédiaire.

17

REVENDICATIONS

1. Pince-test de circuit intégré, caractérisée en ce qu'elle comprend un corps isolant (11) qui comporte un certain nombre de contacts (20) destinés à venir en liaison avec les entrées-sorties du circuit intégré (5), deux leviers (40) reliés entre eux par au moins une entretoise (45, 46), chaque levier (40) ayant sa partie inférieure qui se termine par au moins un crochet (43), chaque levier comportant une articulation (26) de manière à permettre une rotation par rapport à un axe parallèle à ces entretoises, ces leviers (40) étant articulés sur ce corps (11), un circuit imprimé (29) fixé sur ce corps isolant (11), et un câble de liaison (57) qui est connecté à ce circuit imprimé.

2. Pince-test de circuit intégré selon la revendication 1, caractérisée en ce que les leviers (40) de chaque partie sont reliés par deux entretoises (45, 46), un ressort (50) correspondant à chaque levier étant axé sur l'une de ces entretoises (45) de manière à transmettre par pression (F) sur le sommet de la pince-test un couple de rotation aux leviers autour de leur articulation (26) et à interdire tout désencliquetage de ladite pince-test.

3. Pince-test selon la revendication 1, caractérisée en ce que le corps isolant (11) comporte des portées inclinées (28) qui permettent de limiter la rotation des leviers (40).

4. Pince-test selon la revendication 1, caractérisée en ce que le circuit intégré (5) est monté dans un connecteur (2), et en ce que les contacts (20) viennent en liaison sur les zones de contacts (3) de ce connecteur (2).

5. Pince-test selon la revendication 4, caractérisée en ce que, le circuit intégré (5) étant bloqué dans ce connecteur (2) grâce à une pince de verrouillage (1) qui comporte des tétons (7), chaque levier (40) comporte un bras inférieur comprenant une pente d'accrochage (44) qui coopère avec les tétons (7) d'appui de la pince de verrouillage (1) du connecteur.

18

6. Pince-test selon la revendication 1, caractérisée en ce qu'elle comporte des contacts (20) "à pompe" qui comprennent un ressort (24) en boudin dans le sens vertical.

7. Pince-test selon la revendication 6, caractérisée en ce que chaque contact-test "à pompe" (20) est réalisé en matériau conducteur électrique comprenant :
   - un doigt de contact (21);
   - une tige tutrice (23) de diamètre inférieur à celui du doigt (21);
   - une collerette (22) de diamètre supérieur à celui du doigt (21) et située entre ce dernier et la tige tutrice (23);
   - un ressort de pression à boudin, enfilé sur la tige tutrice (23), qui assure la force d'appui du contact-test (20) nécessaire pour garantir un contact électrique stable;
et en ce que chaque contact-test (20) est disposé dans une alvéole formée par :
   - un trou de guidage (19) de la paroi latérale (14) du corps isolant (11), dans lequel coulisse le doigt de contact (21);
   - un logement (18), de section supérieure à celle du trou (19), qui contient le ressort de pression (24) et la tige tutrice (23);
   - une face de retenue (17), formée par le changement de section entre le trou (19) et le logement (18), sur laquelle vient s'appuyer la collerette (22) du contact-test (20) en position repos.

8. Pince-test selon la revendication 7, caractérisée en ce que chaque alvéole est fermée à sa partie supérieure par le circuit imprimé (29) dont le trou métallisé (32) correspondant, de diamètre inférieur à celui du ressort de pression (24), assure le passage et le guidage de l'extrémité supérieure de la tige tutrice (23) lorsque le contact-test (20) coulisse dans son alvéole, l'extrémité supérieure du ressort de pression (24) venant en appui sur la pastille (33) du trou métallisé de guidage (32).

9. Pince-test selon la revendication 7, caractérisée en ce que chaque ressort de pression (24) est en matériau conducteur électrique (23) et a son extrémité inférieure en appui sur la collerette

(22) et les spires en contact de la tige tutrice (23) sur toute la longueur de celle-ci et son extrémité supérieure est en appui sur la pastille (33) du trou métallisé (32) du circuit imprimé (29) de manière à réaliser la liaison électrique entre le doigt de contact (21) et le trou métallisé (31) correspondant.

10. Pince-test selon la revendication 1, caractérisée en ce qu'elle comprend des contacts insérés à force dans le circuit (29) pour constituer une fiche déconnectable.

11. Pince-test selon la revendication 1, caractérisée en ce qu'elle comprend des fourches auto-dénudantes insérées à force dans le circuit (29) pour raccorder un câble en nappe.

12. Pince-test selon la revendication 1, caractérisée en ce qu'elle comprend des fourches "relais" insérées dans le circuit (29) pour braser les fils du câble (57).

13. Pince-test selon la revendication 1, caractérisée en ce qu'est réalisée une brasure directe des fils du câble de liaison sur le circuit (29).

14. Pince-test selon la revendication 1, caractérisée en ce que le circuit (29) comporte une ouverture (30), en ce que le corps isolant comporte un trou (13) de passage qui prolonge cette ouverture et en ce que le toron du câble de liaison (57) passe par cette ouverture (30) du circuit (29) prolongée par ce trou de passage (13), l'extrémité du toron de fil étant épanouie à l'intérieur du logement interne (12), chaque fil (56) passant dans un trou guide-fil (16), et son extrémité dénudée (58) entrant dans un trou métallisé (31), la gaine étant en butée contre la face intérieure (39) du circuit (29), cette extrémité dénudée (58) qui traverse le circuit (29) étant brasée dans ce trou métallisé (31) sur la pastille (37) de la face extérieure (38) du circuit (29).

15. Pince-test selon la revendication 4, caractérisée en ce qu'elle comprend au moins un contact glissant.

16. Pince-test selon la revendication 15, caractérisée en ce que chaque contact-test glissant doit être enfiché dans l'alvéole (6) du contact (3) du connecteur et assurer le contact électrique avec celui-ci grâce à une pression latérale exercée sur une partie de ce contact (3) par serrage de la tête élastiquement déformable du contact-test-.

17. Pince-test selon la revendication 15, caractérisée en ce que ce connecteur comprenant des contacts présentant un bras élastiquement déformable, l'entrée de l'alvéole (6) contenant le contact (3) qui a un corps en forme de U et un bras élastique constitue le réceptacle de la tête du contact-test glissant de la pince-test (10).

18. Pince-test selon la revendication 15, caractérisée en ce que ce contact-test (70) est composé d'une tête fendue (72) dont les deux branches souples (71) séparées par la fente (73) forment une lyre et peuvent se déformer élastiquement par pincement lors de son insertion.

19. Pince-test selon la revendication 18, caractérisée en ce que la tête fendue (72) est solidaire d'une tige (74) logée dans l'alvéole (76) du corps isolant (11) de la pince-test (10), la tige (74) est prolongée à son extrémité supérieure d'un picot (75) dont l'insertion et la brasure dans le trou métallisé (32) du circuit imprimé (29) assurent à la fois la fixation mécanique du contact-test (70) dans la pince-test (10) et l'interconnexion électrique vers le câble de liaison (57) via les pistes (34).

20. Pince-test selon la revendication 15, caractérisée en ce que ce contact-test (80) est composé d'une lame (83) dont l'extrémité inférieure se termine par une branche recourbée (81) qui peut se déformer élastiquement par pincement lors de son insertion, cette lame (83) étant logée dans une alvéole (85) du corps isolant (11), prolongée à son extrémité supérieure d'un picot (84) assurant la fixation mécanique et l'interconnexion électrique du contact-test (80) sur la pince-test (10).

21. Pince-test selon la revendication 1, caractérisée en ce que chaque levier (40') a son bras supérieur (41') qui forme un angle d'environ 150° avec le bras inférieur 42'.

22. Pince-test selon la revendication 1, caractérisée en ce que, le circuit intégré étant brasé directement sur sa carte-support, ladite pince-test comporte des crochets supplémentaires (90) disposés dans le prolongement des bras inférieurs (42) des leviers qui s'encliquent dans quatre trous (93) percés dans la carte-support (4) au quatre coins du circuit intégré.

23. Pince-test selon la revendication 22, caractérisée en ce que ces crochets supplémentaires (90) sont munis d'une pente d'encliquetage (92) pour faciliter leur insertion dans les trous (93) de la carte-support (4) et en ce que le bord (91) de ces crochets (90) est dans le prolongement du bord du bras inférieur (42') venant en appui sur la face d'arrêt (36) du corps isolant (11).

24. Pince-test selon la revendication 1, caractérisée en ce que, le circuit intégré étant un boîtier possédant deux rangées de plots alternés sur les quatre côtés et les deux faces, ladite pince comporte à sa périphérie des contacts-test (20) "à pompe" sur deux rangées alternées.

25. Pince-test selon la revendication 24, caractérisée en ce que les bras inférieurs (42') des leviers munis des petits crochets (90) permettant leur encliquetage dans les trous (93) de la carte-support.

**FIG_1**

**FIG_2**

FIG_3

FIG_4

0181806

# FIG_5

39

30

23 24
21 22
19 20

2 4 6 8 10 12 14 16
1 3 5 7 9 11 13 15 17

31

35 34

32 33

29

# FIG_6

25 31 37 13 30 38 32

29

24 15

23 39

F 18 F

14

22

17 16

19 12 11

21

20

# FIG_7

26 28 36

1 3 5 7 9 11 13 15 17 37 38

2 4 6 8 10 12 14 16 18

19 20

55 21 22

23 24

A A

13

# FIG_8

# FIG_9

# FIG_10

# FIG_12

FIG_11

FIG_13

B

C

77

29

86

75

84

76

85

80

70

83

74

71

72

81

73

B

C

82

Coupe C.C

5/12

0181806

0181806

# FIG_14

# FIG_15

# FIG_16

# FIG_17

0181806

FIG_18

# FIG_19

# FIG_20

0181806

FIG_21

FIG_22

# FIG_23

# FIG_24

# FIG_25

# FIG_26

10'

93

21'

95

0181806

**0181806**
Numero de la demande

Office européen
des brevets

**RAPPORT DE RECHERCHE EUROPEENNE**

EP   85 40 2072

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int Cl 4) |
|---|---|---|---|
| Y | DE-A-2 117 844  (SIEMENS AG)<br><br>*   Page   2,   avant-dernier paragraphe; page 4, paragraphe 2; revendications 1-4; figures 1,2 *<br><br>--- | 1-3,6,<br>7,24 | G 01 R   1/073 |
| Y | GB-A-1 384 550  (INTERNATIONAL COMPUTERS LTD.)<br>*  Figure 3; page 2, lignes 49-58 * | 1-3,6,<br>7,24 | |
| A | | 8 | |
| A | DE-A-3 218 491  (P. STEINBRÜCK)<br>* Abrégé; figure 1; revendication 1 * | 4,15 | |
| A | US-A-3 500 288  (K.J. STARTIN et al.)<br>* Abrégé; figures 1-7 * | 22,23,<br>25 | DOMAINES TECHNIQUES RECHERCHES (Int. Cl.4)<br><br>G 01 R<br>H 01 R<br>H 05 K |
| A | GB-A-1 246 101  (ELECTROSIL LTD.)<br>*  Figures  1-9;  page  1, lignes 48-88 * | 15-17 | |
| A | FR-A-2 328 199  (C. EVERETT)<br><br>---            -/- | | |

Le présent rapport de recherche a été établi pour toutes les revendications

| Lieu de la recherche | Date d'achèvement de la recherche | Examinateur |
|---|---|---|
| LA HAYE | 27-01-1986 | KAUFFMANN J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEBForm 1503 03 82

# Office européen des brevets

# RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernee | CLASSEMENT DE LA DEMANDE (Int Cl 4) |
|---|---|---|---|
| A | US-A-4 112 363  (MORRISON et al.)  ----- | | |

DOMAINES TECHNIQUES RECHERCHES (Int Cl.4)

Le présent rapport de recherche a été établi pour toutes les revendications

| Lieu de la recherche LA HAYE | Date d'achèvement de la recherche 27-01-1986 | Examinateur KAUFFMANN J. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D . cité dans la demande
L : cité pour d'autres raisons

& : membre de la même famille, document correspondant

OEB Form 1503 03 82